# EUROPEAN PATENT APPLICATION

(11) **EP 2 403 326 A2**
(43) Date of publication of application: **04.01.2012**
(21) Application number: 11171606.4
(22) Date of filing: 28.06.2011
(51) Int. Cl.: H05K 5/00

(54) **Electronic Device**

(30) Priority: 29.06.2010 JP 2010147004
(71) Applicant: Funai Electric Co., Ltd., Daito-shi, Osaka 574-0013 (JP)
(72) Inventor: Yamanaka, Takahito, Daito-shi, Osaka 574-0013 (JP)
(74) Representative: Grünecker, Kinkeldey, Stockmair & Schwanhäusser

(57) **Abstract**

An electronic device includes a front cabinet, a wiring board and a lens member. The front cabinet includes a rear face having a pair of hook tabs. Each of the hook tabs has a distal end with a prong. The wiring board includes a plurality of LEDs and a pair of first through-holes. The wiring board is attached to the rear face of the front cabinet such that the hook tabs of the front cabinet extend through the first through-holes. The prongs of the hook tabs engage peripheral edges of the through-holes of the wiring board, respectively. The lens member includes a pair of second through-holes. The lens member is disposed between the rear face of the front cabinet and the wiring board such that the hook tabs of the front cabinet extend through the second through-holes, respectively.

## Description

### CROSS-REFERENCE TO RELATED APPLICATIONS

This application claims priority to Japanese Patent Application No. 2010-147004 filed on June 29, 2010. The entire disclosure of Japanese Patent Application No. 2010-147004 is hereby incorporated herein by reference.

### BACKGROUND

### Field of the Invention

The present invention generally relates to an electronic device. More specifically, the present invention relates to an electronic device with an LED and a lens member.

### Background Information

A television set, a personal computer, or other such electronic device conventionally includes a wiring board with indicator-use LEDs and a lens member that transmits light from the LEDs. The wiring board and the lens member are superposed and attached to a rear face of a front cabinet of the electronic device. With this conventional attachment structure, a lens assembly is made by fixing the wiring board with the LEDs to the transparent lens member having attachment components at both ends. The attachment components at the ends of the lens member of this lens assembly are superposed with bosses that protrude from the rear face of the front cabinet. Then, these parts are fixed with screws (see Japanese Laid-Open Patent Application Publication No. 2009-32760, for example).

With another conventional structure, positioning pins and fixing pins provided to an LED holder are inserted in fixing holes and teardrop-shaped positioning holes provided to a printed board. Fixing prongs at the distal ends of the fixing pins are hooked into the fixing holes to assemble the LED holder and the printed board (see Japanese Laid-Open Patent Application Publication No. H8-121430, for example). With yet another conventional structure, fixing protrusions provided to a rear face of a cover are inserted into fixing cut-outs provided to a circuit board. Latching prongs on the fixing protrusions are latched to the edges of the fixing cut-outs to attach the circuit board to the rear face of the cover (see Japanese Laid-Open Patent Application Publication No. H9-148765, for example).

### SUMMARY

It has been discovered that, with the attachment structure in Japanese Laid-Open Patent Application Publication No. 2009-32760, a step in which the wiring board is fixed to the lens member to make the lens assembly, and a screw fastening step in which the fixing components at both ends of the lens member of the lens assembly are fixed with the screws to bosses of the rear face of the front cabinet are necessary. Thus, a problem is that assembly entails a great deal of work.

Meanwhile, it has also been discovered that, with the attachment structures in Japanese Laid-Open Patent Application Publications Nos. H8-121430 and H9-148765, two members (e.g., the LED holder and the printed board in Japanese Laid-Open Patent Application Publication No. H8-121430, and the cover and the circuit board in Japanese Laid-Open Patent Application Publication No. H9-148765) are fixed by the fixing pins with the fixing prongs and by the fixing protrusions with the latching prongs at their distal ends, respectively. However, these attachment structures cannot be applied to fix three members.

The present invention was conceived in light of the above-mentioned problems. One object of the present invention is to provide an electronic device with which an assembly work of a lens member and a wiring board to a front cabinet becomes easier.

In accordance with one aspect, an electronic device includes a front cabinet, a wiring board and a lens member, The front cabinet includes a rear face having a pair of hook tabs. Each of the hook tabs has a distal end with a prong- The wiring board includes a plurality of LEDs and a pair of first through-holes. The wiring board is attached to the rear face of the front cabinet such that the hook tabs of the front cabinet extend through the first through-holes. The prongs of the hook tabs engage peripheral edges of the through-holes of the wiring board, respectively. The lens member is arranged with respect to the wiring board to transmit light from the LEDs. The lens member includes a pair of second through-holes. The lens member is disposed between the rear face of the front cabinet and the wiring board such that the hook tabs of the front cabinet extend through the second through-holes, respectively.

With the electronic device, it is possible to provide an electronic device with which an assembly work of a lens member and a wiring board to a cabinet becomes easier.

These and other objects, features, aspects and advantages will become apparent to those skilled in the art from the following detailed description, which, taken in conjunction with the annexed drawings, discloses a preferred embodiment.

### BRIEF DESCRIPTION OF THE DRAWINGS

Referring now to the attached drawings which form a part of this original disclosure.

FIG. 1 is a partial front elevational view of an electronic device in accordance with one embodiment;

FIG. 2 is a partial rear perspective view of a lens member, a wiring board and a front cabinet of the electronic device illustrated in FIG. 1, illustrating that the lens member and the wiring board are attached to the front cabinet;

FIG. 3 is an exploded partial rear perspective view of the lens member, the wiring board and the front cabinet of the electronic device illustrated in FIG. 1;

FIG. 4 is an exploded partial rear perspective view of the lens member, the wiring board and the front cabinet of the electronic device illustrated in FIG. 1, illustrating the lens member is attached to the front cabinet;

FIG. 5 is a partial cross sectional view of the lens member, the wiring board and the front cabinet of the electronic device as seen along section line taken along V-V in FIG. 2; and

FIG. 6 is a partial cross sectional view of the lens member, the wiring board and the front cabinet of the electronic device as seen along section line taken along VI-VI in FIG. 2.

### DETAILED DESCRIPTION OF EMBODIMENTS

A preferred embodiment will now be explained with reference to the drawings. It will be apparent to those skilled in the art from these disclosures that the following descriptions of the preferred embodiment are provided for illustration only and not for the purpose of limiting the invention as defined by the appended claims and their equivalents.

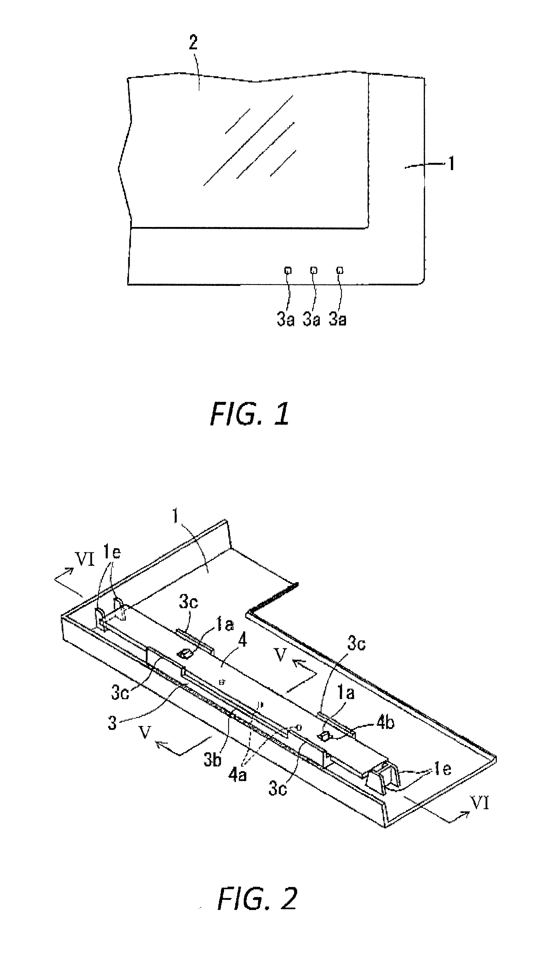

FIG. 1 is a partial front elevational view of a liquid crystal television set (e.g., electronic device). The liquid crystal television set is a display device mainly with a cabinet, a liquid crystal module, and a plurality of optical sheets. The cabinet includes a rectangular front cabinet 1 and a rear cabinet (not shown). The liquid crystal module is housed within an inner space defining between the front cabinet 1 and the rear cabinet. The liquid crystal module includes a backlight unit (not shown), a frame (not shown), a bezel (not shown) and a liquid crystal panel 2. As illustrated in FIGS. 2-6, the liquid crystal television set further includes a lens member 3 and a wiring board 4. The lens member 3 and the wiring board 4 form an indicator indicating operational statuses of the liquid crystal television set. The lens member 3 and the wiring board 4 are attached and fixed to a rear face of the front cabinet 1 at a lower frame part of the front cabinet 1.

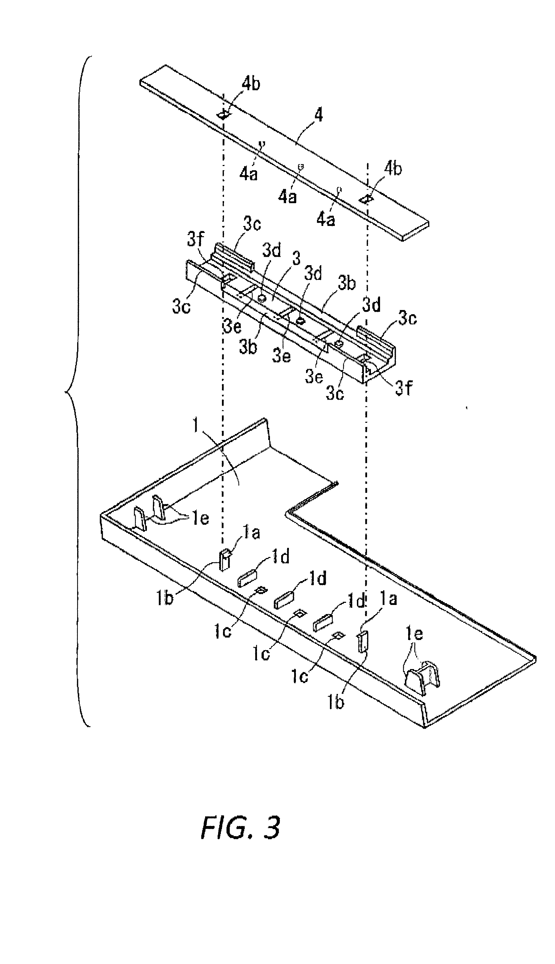

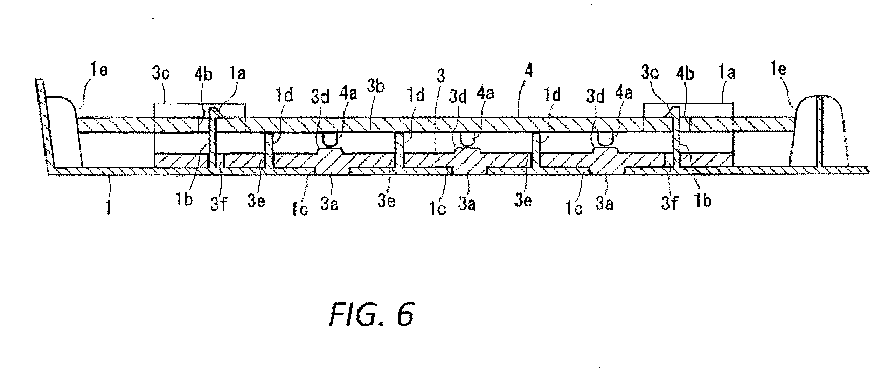

As illustrated in FIGS. 2-6, the front cabinet I includes a pair of hook tabs 1b, a plurality of (three in this embodiment) small, square openings 1c, a plurality of (three in this embodiment) light blocking tabs 1d and a pair of positioning ribs 1e (e.g., first positioning portions). As illustrated in FIGS. 3 and 6, the left and right hook tabs 1b protrude rearward from the rear face at the lower frame part of the front cabinet 1, respectively. Each of the hook tabs 1b has a prong 1a at its distal end. The prongs 1a of the hook tabs 1b each stick out toward the other hook tab 1b. The openings 1c are formed at spaced apart locations in a lateral row between the hook tabs 1b. The light blocking tabs 1d protrudes rearward between these openings 1c and also between the opening 1c at the left end and the left hook tab 1b. When the lens member 3 and the wiring board 4 are attached as discussed below, the height of the light blocking tabs 1d is such that distal ends of the light blocking tabs 1d are close to the front face of the wiring board 4. The positioning ribs 1e position the wiring board 4 in a lateral direction of the liquid crystal television set (i.e., left and right directions in FIG. 1) with respect to the front cabinet 1. The positioning ribs 1e are located on both sides of each of the hook tabs 1b on the rear face of the lower frame part of the front cabinet 1. In other words, both of the hook tabs 1b are laterally located between the positioning ribs 1e. When the lens member 3 and the wiring board 4 are attached to the front cabinet 1, the lens member and the wiring board 4 are laterally disposed between the positioning ribs 1e. Positioning faces of the positioning ribs 1e has inclined guide faces so as to facilitate the work of attaching the wiring board 4. In other words, the positioning faces of the positioning ribs 1e have a maximum lateral gap width therebetween at distal ends of the positioning ribs 1e. Lateral side edges of the wiring board 4 are laterally engaged to the positioning faces of the positing ribs 1e. The front cabinet 1 is integrally formed by molding as a one-piece, unitary member.

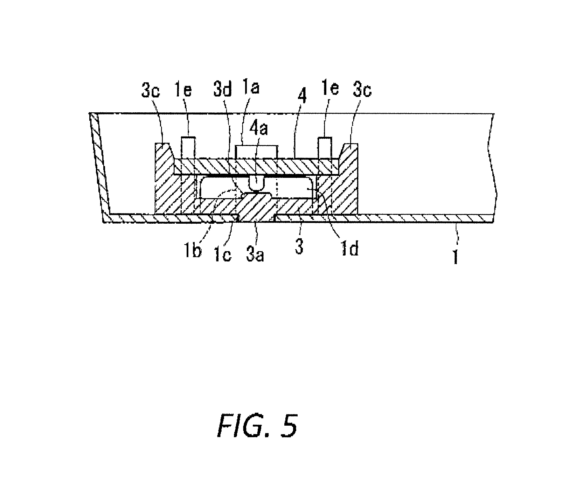

The lens member 3 is a flat, rectangular member that is injection molded from a transparent synthetic resin. The lens member 3 is integrally formed as a one-piece, unitary member. The length of the lens member 3 in the lengthwise direction of lens member 3, which is parallel to the lateral direction of the liquid crystal television set when the lens member 3 is attached to the front cabinet 1, is considerably less than that of the wiring board 4. As illustrated in FIGS. 3, 5 and 6, the lens member 3 includes a plurality of (three in this embodiment) convex components 3a, a pair of higher convex edge components 3b, a plurality of (four in this embodiment) positioning ribs 3c (e.g., second positioning portions) 3c, a plurality of (three in this embodiment) light-guide protrusions 3d, a plurality of slits 3c and a pair of rectangular through-holes (e.g., second through holes) 3f. The convex components 3a are formed along the lengthwise direction of the lens member 3. The convex components 3a are fitted to and disposed through the openings 1c in the lower frame part of the front cabinet 1, respectively, such that the convex components 3a are exposed frontward through the openings 1c, respectively. The convex edge components 3b support the wiring board 4. The convex edge components 3b are formed on both upper and lower side edges of a rear face of the lens member 3 (i.e., upper face in FIGS- 3, 5, and 6) along the side edges extending in the lengthwise direction of the lens member 3. The positioning ribs 3c widthwisely position the wiring board 4 in a height direction (i.e.. upper and lower directions in FIG. 1) of the liquid crystal television set with respect to the front cabinet 1 and the lens member 3, The positioning ribs 3c protrude from both lateral ends of the convex edge components 3b, respectively. The positioning ribs 3c include positioning inner faces. As illustrated in FIG. 5, distal end portions (e.g., upper half portions) of the positioning inner faces are formed as inclined guide faces, respectively so as to facilitate the work of attaching the wiring board 4 to the lens member 3, In other words, the positioning inner faces of the positioning ribs 3c have a maximum gap width therebetween at distal ends of the positioning ribs 3c. Widthwise side edges of the wiring board 4 are widthwisely engaged to the positioning inner faces of the positioning ribs 3c. Thus, the wiring board 4 are positioned in a widthwise direction of the wiring board 4, which is parallel to the height direction of the liquid crystal television set when the wiring board 4 is attached to the front cabinet 1, relative to the front cabinet 1.

As illustrated in FIGS. 5 and 6, the convex components 3a fit into the openings 1c in the front cabinet 1, respectively. The convex components 3a are formed in the same number as the openings 1c and spaced part on a front face of the lens member 3 (i.e., the lower face in FIGS. 5 and 6). The light-guide protrusions 3d are formed in the same number corresponding to the convex components 3a on the rear face of the lens member 3 (i.e., the upper face in FIGS. 5 and 6). The light-guide protrusions 3d guide light emitted from LEDs (light emitting diodes) 4a of the wiring board 4. Furthermore, the slits 3e are formed in the same number and at the same spacing as the light blocking tabs 1d between facing portions of the lens member 3 that face the LEDs 4a, respectively. The light blocking tabs 1d of the front cabinet 1 are inserted into the slits 3e, respectively. The left and right through-holes 3f are farmed at substantially the same spacing as the hook tabs 1b near both ends of the lens member 3. The hook tabs 1b of the front cabinet 1 are inserted into the through-holes 3f, respectively.

The wiring board 4 is a flat, slender wiring board having a length that is equal to the spacing between the left and right positioning ribs 1e of the front cabinet 1. The LEDs 4a are electrically coupled to the wiring board 4. The LEDs 4a are disposed in the same number (i.e., three in this embodiment) and at the same spacing as the convex components 3a and the light-guide protrusions 3d of the lens member 3 on the front face of the wiring board 4 (i.e., the lower face in FIGS. 3, 5, and 6). The LEDs 4a emit white light, R (red), G (green) or B (blue) light. The wiring board 4 has a pair of rectangular through-holes (e.g., first through-holes) 4b. The left and right through-holes 4b are formed at substantially the same spacing as the hook tabs 1b in the wiring board 4. The hook tabs 1b of the front cabinet 1 are inserted into the through-hole 4b. When the wiring board 4 and the lens member 3 are attached to the rear face of the front cabinet 1, the through-holes 4b of the wiring board 4 and the through-holes 3f of the lens member 3 are superposed in an overlapping positional relationship. In other words, the through-holes 4b of the wiring board 4 and the through-holes 3f of the lens member 3 are aligned as viewed in a direction perpendicular to the rear face of the front cabinet.

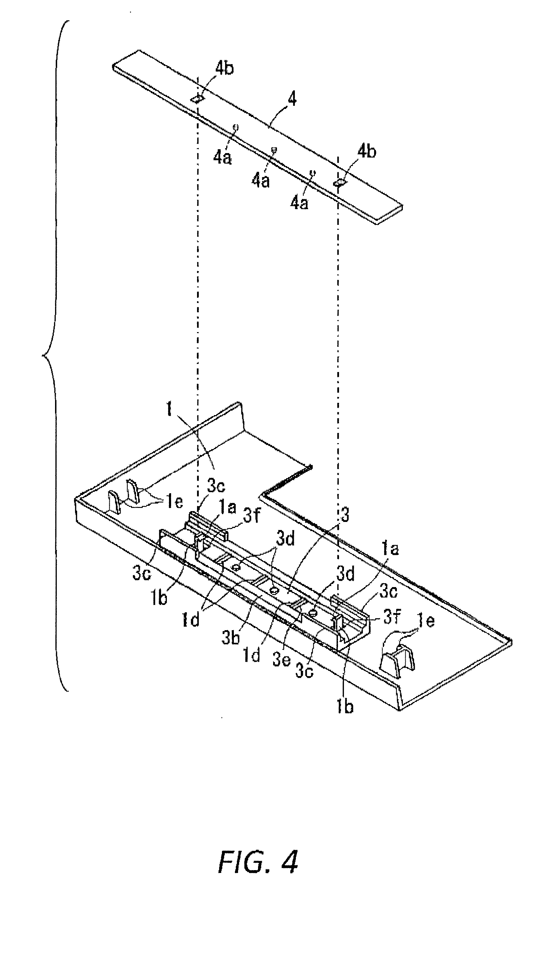

The attachment structure in this embodiment can be efficiently assembled as follows. First, as illustrated in FIGS. 4 to 6, the hook tabs 1b of the front cabinet 1 are inserted into the through-holes 3f of the lens member 3. The convex components 3a of the lens member 3 are fitted into the openings 1c of the front cabinet 1 to position the lens member 3 with respect to the front cabinet 1. The light blocking tabs 1d of the front cabinet 1 are inserted into the slits 3e of the lens member 3. As a result, the lens member 3 is installed on the rear face of the front cabinet 1. Furthermore, as illustrated in FIGS. 2, 5 and 6, the wiring board 4 is arranged such that the LEDs 4a of the wiring board 4 face the rear face of the front cabinet 1. The hook tabs 1b of the front cabinet 1 are inserted into the through-holes 4b of the wiring board 4 so that the wiring board 4 is superposed with the lens member 3. The wiring board 4 is positioned in the widthwise and lengthwise directions of the wiring board 4 (i.e., the up and down, and left and right directions of the liquid crystal television set) with respect to the front cabinet 1 by the positioning ribs 3c formed on the lens member 3 and by the positioning ribs 1e formed on the rear face of the front cabinet 1, respectively. The prongs 1a at the distal ends of the hook tabs 1b are latched to peripheral edges of the through-holes 4b of the wiring board 4, respectively. As a result, the lens member 3 and the wiring board 4 are clamped and fixed between the rear face of the front cabinet I and the prongs 1a of the hook tabs 1b.

As discussed above, the attachment structure in this embodiment does not involve tilting or sliding the lens member 3 or the wiring board 4. The only work involve is to move the lens member 3 and the wiring board 4 from the distal end side of the hook tabs 1b in one direction toward the base side of the hook tabs 1b. As a result, the hook tabs 1b are inserted into the through-holes 3f and 4b of the lens member 3 and the wiring board 4, respectively. Furthermore, at the same time, the prongs 1a are latched to the peripheral edges of the through-holes 4b of the wiring board 4, which completes the assembly. Therefore, the assembly work itself is extremely simple, and there is no need for a step of making a lens assembly as with the conventional attachment structure, or for a step of screwing the assembly to bosses on the rear face of the front cabinet. Therefore, the assembly work becomes much easier.

Furthermore, with the attachment structure of this embodiment, a fixing means is employed whereby the hook tabs 1b are inserted into the through-holes 3f and 4b of the lens member 3 and the wiring board 4 so that the peripheral edges of the through-holes 4b are latched by the prongs 1a at the distal end of the hook tabs 1b. Furthermore, the positioning ribs 1e for the lengthwise direction of the wiring board 4 are formed on the rear face of the front cabinet 1. When a lens member that is longer and larger than a wiring board and on which fixing components are integrally formed at both ends is used, there is the cost of a mold for forming the lens member, and the cost of the lens member is higher. Thus, this approach is economically disadvantageous. Also, when attaching a lens assembly that features a large lens member such as this, a large attachment space is needed on the back of the front cabinet, which is a problem in that it reduces latitude in layout. On the other hand, with the attachment structure of this embodiment, the length of the lens member 3 in the lateral direction of the liquid crystal television set is less than that of the wiring board 4. Thus, the lens member 3 can be more compact. As a result, expenses are saved for the material of the lens member 3 and the mold used to form the lens member 3. Furthermore, the attachment space can be smaller than when a larger lens assembly is attached. Accordingly, not only is space saved, but greater latitude in layout is also afforded.

Also, with the attachment structure of this embodiment, the light blocking tabs 1d prevent leakage from the LEDs 4a to adjacent LEDs 4a. Thus, whether or not the LEDs 4a are lit can be easily discerned visually by looking at the convex components 3a of the lens member 3 exposed in the openings 1c of the front cabinet 1, from the front face side of the liquid crystal television set.

With the attachment structure of this embodiment, the lens member 3 and the wiring board 4 are attached to the rear face of the front cabinet 1 of the liquid crystal television set. However, the attachment structure can be applied to various other kinds of electronic device besides the liquid crystal television set.

With the liquid crystal television set of the this embodiment, in a single assembly step, the two hook tabs 1b of the front cabinet 1 are inserted in the two through-holes 3f of the lens member 3 to install the lens member 3 on the rear face of the front cabinet 1, the two hook tabs 1b of the front cabinet 1 are inserted into the two through-holes 4b of the wiring board 4 so that the wiring board 4 is superposed with the lens member 3, and the prongs 1a at the distal ends of the two hook tabs 1b are latched to the peripheral edges of the two through-holes 4b in the wiring board4. As a result, the lens member 3 and the wiring board 4 are clamped and fixed between the rear face of the front cabinet 1 and the prongs 1a at the distal ends of the two hook tabs 1b. Thus, merely doing this allows the lens member 3 and the wiring board 4 to be efficiently attached to the rear face of the front cabinet 1. Therefore, there is no need for a step of making a lens assembly, or a step of screwing this assembly to bosses on the rear face of the front cabinet, as is the case with the conventional attachment structure. Accordingly, the assembly work is much easier. Furthermore, the lens member 3 and wiring board 4 will not tilt or slide, and the only work entailed by assembly is to move the lens member 3 and wiring board 4 from the distal end side of the hook tabs 1b toward the base side so that the hook tabs 1b are inserted into and latched in the through-holes 3f and 4b. Thus, the assembly work itself is simple, and work efficiency is good.

With the attachment structure of this embodiment, two through-holes 3f and 4b are formed in each of the lens member 3 and the wiring board 4 at overlapping positions. The two hook tabs 1b protruding from the rear face of the front cabinet I are inserted in the through-holes 3f and 4b. The prongs 1 a at the distal ends of the hook tabs 1b are latched to the peripheral edges of the through-holes 4b of the wiring board4. Thus, there is no need to make the lens member 3 longer than the wiring board 4 and to form fixing components for screw fastening at both ends, as is the case with the conventional attachment structure. The length of the lens member 3 in the lateral direction of the liquid crystal television set is less than that of the wiring board 4, which allows the lens member 3 to be more compact. Accordingly, expenses are saved for the material of the lens member 3 and the mold used to form the lens member 3, which allows the cost to be brought down. Furthermore, the attachment space is also smaller. Thus, a space saving is achieved and at the same time greater layout latitude is afforded. Furthermore, if outer peripheral edge of a wiring board is fixed with hook tabs protruding from a rear face of a front cabinet, no fewer than three hook tabs are necessary. However, the hook tabs 1b are inserted and latched in the through-holes 3f and 4b of the lens member 3 and the wiring board 4. Thus, the parts can be securely fixed with just two hook tabs 1b.

With the liquid crystal television set of this embodiment, the positioning ribs 1e for the lengthwise direction of the wiring board 4 are formed on the rear face of the front cabinet 1. The positioning ribs 3c for the widthwise direction of the wiring board 4 are formed on the lens member 3. The wiring board 4 is positioned in the lengthwise and widthwise directions by these positioning ribs 1e and 3c, respectively. Thus, there is no need to form the lens member 3 longer than the wiring board 4 and to form positioning ribs for the lengthwise direction at both ends of the lens member 3. Thus, the length of the lens member 3 in the lengthwise direction can be less than the length of the wiring board 4, making the lens member 3 more compact, lowering the cost, saving space, and affording greater latitude in layout. Also, the lens member 3 on which are formed positioning ribs 3c for the widthwise direction of the wiring board 4 is not that complicated in shape. Thus, combined with the above-mentioned smaller size, another advantage is that it can be formed with an inexpensive mold.

Also, with the liquid crystal television set of this embodiment, the slits 3e are formed between the facing portions of the lens member 3 that face the LEDs 4a, respectively. The light blocking tabs 1d that protrude from the rear face of the front cabinet 1 are inserted into the slits 3a. The distal ends of the light blocking tabs 1d are brought close to the front face of the wiring board 4. Thus, light from the LEDs 4a is blocked by the light blocking tabs 1d and will not lead toward adjacent LEDs 4a. Thus, whether or not the LEDs are lit can be easily discerned visually by looking at the exposed part of the lens member 3 from the front face side of the liquid crystal television set.

### GENERAL INTERPRETATION OF TERMS

In understanding the scope of the present invention, the term "comprising" and its derivatives, as used herein, are intended to be open ended terms that specify the presence of the stated features, elements, components and groups, but do not exclude the presence of other unstated features, elements, components and groups. The foregoing also applies to words having similar meanings such as the terms, "including", "having" and their derivatives. Also, the terns "part," "section," "portion," "member" or "clement" when used in the singular can have the dual meaning of a single part or a plurality of parts. As used herein to describe the present invention, the following directional terms "forward, rearward, above, downward, vertical, horizontal, below and transverse" as well as any other similar directional terms refer to those directions of an electronic device equipped with the present invention. Accordingly, these terms, as utilized to describe the present invention should be interpreted relative to an electronic device equipped with the present invention as used in the normal operating position.

While a preferred embodiment have been chosen to illustrate the present invention, it will be apparent to those skilled in the art from these disclosures that various changes and modifications can be made herein without departing from the scope of the invention as defined in the appended claims. Furthermore, the foregoing descriptions of the preferred embodiment according to the present invention are provided for illustration only, and not for the purpose of limiting the invention as defined by the appended claims and their equivalents.

## Claims

1. An electronic device comprising:
a front cabinet including a rear face having a pair of hook tabs, each of the hook tabs having a distal end with a prong;
a wiring board including a plurality of LEDs and a pair of first through-holes, the wiring board being attached to the rear face of the front cabinet such that the hook tabs of the front cabinet extend through the first through-holes, and the prongs of the hook tabs engage peripheral edges of the through-holes of the wiring board, respectively; and
a lens member being arranged with respect to the wiring board to transmit light from the LEDs, the lens member including a pair of second through-holes, the lens member being disposed between the rear face of the front cabinet and the wiring board such that the hook tabs of the front cabinet extend through the second through-holes, respectively.

2. The electronic device according to claim 1, wherein
the lens member has a length in a lengthwise direction of the lens member that is less than a length of the wiring board in a lengthwise direction of the wiring board.

3. The electronic device according to claim 1, wherein
the front cabinet further includes a pair of first positioning portions, the wiring board being disposed between the first positioning portions such that the first positioning portions position the wiring board in a lengthwise direction of the wiring board with respect to the front cabinet, and
the lens member further includes a pair of second positioning portions, the wiring board being disposed between the second positioning portions such that the second positioning portions position the wiring board in a widthwise direction of the wiring board with respect to the front cabinet with the widthwise direction of the wiring board being perpendicular to the lengthwise direction of the wiring board.

4. The electronic device according to claim 2, wherein
the front cabinet further includes a pair of first positioning portions, the wiring board being disposed between the first positioning portions such that the first positioning portions position the wiring board in the lengthwise direction of the wiring board with respect to the front cabinet, and
the lens member further includes a pair of second positioning portions, the wiring board being disposed between the second positioning portions such that the second positioning portions position the wiring board in a widthwise direction of the wiring board with respect to the front cabinet with the widthwise direction of the wiring board being perpendicular to the lengthwise direction of the wiring board.

5. The electronic device according to claim 1, wherein
the front cabinet further includes a light blocking tab, the light blocking tab protruding rearward of the front cabinet relative to the rear face of the front cabinet, and
the lens member further includes a slit that is located between facing portions that face the LEDs of the wiring board, respectively, the light blocking tab of the front cabinet being disposed within the slit of the lens member.

6. The electronic device according to claim 2, wherein
the front cabinet further includes a light blocking tab, the light blocking tab protruding rearward of the front cabinet relative to the rear face of the front cabinet, and
the lens member further includes a slit that is located between facing portions that face the LEDs of the wiring board, respectively, the light blocking tab of the front cabinet being disposed within the slit of the lens member.

7. The electronic device according to claim 3, wherein
the front cabinet further includes a light blocking tab, the light blocking tab protruding rearward of the front cabinet relative to the rear face of the front cabinet, and
the lens member further includes a slit that is located between facing portions that face the LEDs of the wiring board, respectively, the light blocking tab of the front cabinet being disposed within the slit of the lens member.

8. The electronic device according to claim 4, wherein
the front cabinet further includes a light blocking tab, the light blocking tab protruding rearward of the front cabinet relative to the rear face of the front cabinet, and
the lens member further includes a slit that is located between facing portions that face the LEDs of the wiring board, respectively, the light blocking tab of the front cabinet being disposed within the slit of the lens member.

9. The electronic device according to claim 1, wherein
the lens member further includes a plurality of light-guide protrusions on a rear face of the lens member, the light-guide protrusions being formed at locations on the rear face of the lens member that face the LEDs of the wiring board, respectively.

10. The electronic device according to claim 1, wherein
the front cabinet further includes a plurality of openings, and
the lens member further includes a plurality of convex components on a front face of the lens member, the convex components being fitted to the openings of the front cabinet, respectively.
